(19) Europäisches Patentamt
European Patent Office
Office européen des brevets

(11) EP 2 381 375 A1

(12) EUROPÄISCHE PATENTANMELDUNG

(43) Veröffentlichungstag:
26.10.2011 Patentblatt 2011/43

(51) Int Cl.:
*G06F 17/50* (2006.01)   *H01L 29/78* (2006.01)

(21) Anmeldenummer: 11173339.0

(22) Anmeldetag: 05.10.2005

(84) Benannte Vertragsstaaten:
AT BE BG CH CY CZ DE DK EE ES FI FR GB GR HU IE IS IT LI LT LU LV MC NL PL PT RO SE SI SK TR

(30) Priorität: 05.10.2004 DE 102004048278

(62) Dokumentnummer(n) der früheren Anmeldung(en) nach Art. 76 EPÜ:
05795964.5 / 1 797 514

(71) Anmelder:
• X-FAB Semiconductor Foundries AG
99097 Erfurt (DE)
• Alpha Microelectronics GmbH
15236 Frankfurt (Oder) (DE)

(72) Erfinder:
• Lerner  Ralf
99085 Erfurt (DE)
• Miesch, Wolfgang
15236 Frankfurt (Oder) (DE)

(74) Vertreter: Leonhard, Frank Reimund
Leonhard - Olgemöller - Fricke
Patentanwälte
Postfach 10 09 62
80083 München (DE)

Bemerkungen:
Diese Anmeldung ist am 08-07-2011 als Teilanmeldung zu der unter INID-Code 62 erwähnten Anmeldung eingereicht worden.

(54) **Verfahren zum rationellen konstruktiven Aufbau von vertikalen Leistungstransistoren**

(57) Verfahren und ein System zum Entwerfen eines vertikalen MOS-Leistungstransistors mit spezifizierter Entwurfsleistung. Das Verfahren umfasst das Zusammensetzen eines Layouts des vertikalen MOS-Leistungstransistors als Kombination von zumindest teilweise unterschiedlichen Layout-Teilstücken mit jeweils bekannten Entwurfsdaten mit zumindest einem ersten Layout-Teilstück, das eine vorgegebene Anzahl an Einzeltransistorzellen aufweist, und das Einstellen der spezifizierten Entwurfsleistung mittels der bekannten Entwurfsdaten und der Anzahl der verwendeten Layout-Teilstücke.

Fig. 6

EP 2 381 375 A1

**Beschreibung**

Die Erfindung betrifft ein Verfahren zur Erzeugung genormter Layout-Teilstücke zum Entwerfen oder konstruktiven Aufbau von vertikalen Leistungstransistoren (DMOS oder IGBT) mit variierbarer Kanalweite, die vom Designer mit der jeweils gewünschten Kanalweite und damit mit entsprechendem Durchgangswiderstand, gezeichnet bzw. entworfen werden können und die mittels elektrischer Parameter in Abhängigkeit der Kanalweite beschrieben werden können (Anspruch 1). Es kann sich sowohl um diskrete als auch um integrierte vertikale Transistoren handeln.

Ein in der Leistungselektronik eingesetzter vertikaler Transistor besteht üblicherweise aus einer Vielzahl von parallel geschalteten Einzeltransistorzellen sowie einem Anschlußkontakt für die Gateelektrode, wie dies beispielsweise beschrieben ist in US-A 5,844,277, dort Fig. 2A bis D sowie Fig. 5-7 und in US-A 5,763,914. Diese Einzeltransistorzellen haben eine gemeinsame Gateelektrode, einen gemeinsamen Drainanschluß auf der Rückseite der Siliziumscheibe und im Silizium getrennte Source- bzw. Wannenanschlüsse, die jedoch durch eine gemeinsame Metallelektrode ebenfalls parallel verschaltet werden. Die Anzahl und Größe der Einzeltransistorzellen ist bestimmend für die Transistorfläche, die Kanalweite und den Durchgangswiderstand, wie dies beschrieben ist in Baliga, Power Semiconductor Devices, 1995 Seiten 367ff. Um den gewünschten Durchgangswiderstand eines vertikalen DMOS-Transistors zu erhalten, muß im derzeitigen Stand der Technik der komplette Transistor mit entsprechender aktiver Fläche und einer den Transistor nach außen hin abschließenden Randstruktur entworfen werden. Um von einem Transistor mit einem ersten Durchgangswiderstand auf einen zweiten mit geändertem Durchgangswiderstand zu kommen, bedeutet das, dass der gesamte Transistor neu entworfen werden muß. Üblicherweise werden die benötigten elektrischen Parameter des vertikalen DMOS-Transistors für jeden unterschiedlichen Transistor getrennt gemessen und beschrieben.

Für den Entwurf von integrierten Schaltkreisen sind Methoden bekannt, den Schaltkreis aus einzelnen Blöcken zusammenzusetzen. So z.B. in US-A 6,769,007 worin ein Zusammensetzen eines integrierten Schaltkreises aus einzelnen Blöcken beschrieben wird. Ebenso wird das Zusammensetzen eines integrierten Schaltkreises oder Teilen davon aus einzelnen extra mit Metallleitbahnen zu verbindenden Blöcken beschrieben: in US-A 6,651,236 und US-A 6,591,408.

**Aufgabe der Erfindung** ist es, ein Verfahren anzugeben, mit dem auf vereinfachte Weise vertikale Leistungstransistoren für unterschiedliche Durchgangswiderstände entworfen werden können.

Die Aufgabe wird gelöst durch ein Verfahren zur Erzeugung genormter Layout-Teilstücke zum Entwerfen von vertikalen MOS-Leistungstransistoren, die für unterschiedliche Leistungen ausgelegt sind. Das Verfahren umfasst die Schritte: Erzeugen zumindest einiger unterschiedlicher Layout-Teilstücke durch Aufteilen eines vollständigen Layouts mit mehreren Einzeltransistorzellen eines vertikalen MOS-Leistungstransistors mit bekannten Entwurfsdaten, Erzeugen mehrerer unterschiedlicher Sorten von Teilstücken, wobei Teilstücke jeder Sorte gleiche Konfiguration und gleiche Entwurfsdaten besitzen und Berechnen der Entwurfsdaten jeder Sorte aus den bekannten Entwurfsdaten des vollständigen Layouts, um genormte Teilstücke für ein auf ein Teilungsraster festgelegtes Layout zu erhalten.

Somit können entsprechende Entwurfshilfsmittel effizient und mit großer Flexibilität hergestellt werden.

Gemäß einem weiteren Aspekt wird die Aufgabe gelöst durch ein Verfahren zum Entwerfen eines vertikalen MOS-Leistungstransistors mit spezifizierter Entwurfsleistung, wobei das Verfahren umfasst: Zusammensetzen eines Layouts des vertikalen MOS-Leistungstransistors als Kombination von zumindest teilweise unterschiedlichen Layout-Teilstücken mit jeweils bekannten Entwurfsdaten mit zumindest einem ersten Layout-Teilstück, das eine vorgegebene Anzahl an Einzeltransistorzellen (2) aufweist, und Einstellen der spezifizierten Entwurfsleistung mittels der bekannten Entwurfsdaten und der Anzahl der verwendeten Layout-Teilstücke.

Somit kann eine Reduzierung des Zeitaufwandes für den Entwurf eines vertikalen Leistungstransistors mit einer bestimmten Aktivfläche für den Entwerfer sowie die Reduzierung des Aufwandes für Messungen und Beschreibung erfolgen. Dem Entwerfer wird ein "Vorentwurf" zur Verfügung gestellt werden, welchen er auf einfache Art und Weise schnell seinen Bedürfnissen entsprechend umgestalten kann. Des weiteren lässt sich eine effiziente parametrische Beschreibung dieses Bauelementes erreichen.

Aufgrund des Verfahrens können Transistoren mit unterschiedlichen Leistungen, d.h. unterschiedlicher Fläche bzw. mit unterschiedlichem Durchgangswiderstand, auf einfache Weise, d.h. schnell und billig konstruiert werden. Durch die angegebenen Entwurfsdaten ist mittels geeigneter Berechnungsverfahren einzelner Transistorparameter aus gegebenen Parametern der Einzelstücke eine einfache Beschreibung der entworfenen Transistoren auf der Basis der Ausgangsstücke möglich.

In einer weiteren Ausführungsform wird die spezifizierte Entwurfsleistung durch die Anzahl der ersten Teilstücke eingestellt wird. Somit kann die gewünschte Leistung einfach berechnet und eingestellt werden

In einer weiteren Ausführungsform sind die Einzeltransistorzellen der ersten Teilstücke von gleicher Konfiguration sind, wodurch standardmäßige Transistorkonfigurationen effizient erstellt werden können.

In einer weiteren Ausführungsform enthalten zumindest einige der Teilstücke Randbereiche, die abschnittsweise zusammenfügbar sind, um einen vollständigen Randbereich im Layout des vertikalen MOS-Leistungstransistors zu bilden. Damit kann der Entwurf ohne Gestaltung neuer Transistorkomponenten, beispielsweise angepasster Randkomponenten erfolgen.

In einer weiteren Ausführungsform weisen Teilstücke mit gleichem Randbereich eine bestimmte Anzahl von stets gleichen Einzeltransistorzellen in gleicher geometrischer Anordnung auf, wodurch die Effizienz noch weiter verbessert wird.

In einer weiteren Ausführungsform umfasst jedes der Teilstücke einen bestimmten Abschnitt des vollständigen Randbereiches. Damit kann in sehr wenigen Schritten eine vollständige Transistorstruktur entworfen werden, da die Randbereiche bereits in den einzelnen Teilstücken integriert sind.

In einer weiteren Ausführungsform wird ein zweites Teilstück verwendet, das zumindest einen Gate-Anschluss aufweist.

In einer weiteren Ausführungsform weist das zweite Teilstück eine bestimmte Anzahl von gleichen Einzeltransistorzellen auf.

In einer weiteren Ausführungsform enthält das zweite Teilstück einen Abschnitt des vollständigen Randbereiches.

In einer weiteren Ausführungsform ist ein drittes Teilstück vorgesehen, das sich zumindest in einer Entwurfseigenschaft von dem ersten und dem zweiten Teilstück unterscheidet. Auf diese Weise kann mit nur drei unterschiedlichen Teilstücken eine Vielzahl von Transistorstrukturen mit unterschiedlichen Leistungen entworfen werden.

In einer weiteren Ausführungsform weisen die ersten, zweiten und dritten Teilstücke Abschnitte des Randbereichs auf, die sich zum vollständigen Randbereich ergänzen.

In einer weiteren Ausführungsform umfasst das Verfahren ferner: Entwerfen mindestens eines zweiten vertikalen Leistungstransistors mit einer zweiten, anderen spezifizierten Entwurfsleistung durch Kombinieren zumindest der ersten, zweiten und dritten Teilstücke zu Bauelementeeinheiten unterschiedlich großer Gesamtfläche, wobei sich die Leistungsabstufung zwischen dem vertikalen MOS-Leistungstransistor und dem zweiten vertikalen MOS-Leistungstransistor durch die Größe eines des die Mitte der Bauelementfläche bildenden Teilstücks ergibt. D.h., verschiedene Transistortypen können mit der vorgegebenen Leistungsabstufung bei Bedarf rasch entworfen werden, wobei keine Schritte für die Gestaltung neuer Layout-Objekte erforderlich sind.

In einer weiteren Ausführungsform ist jedes Teilstück ein genormtes Teilstück, so dass damit die Teilstücke in beliebiger Weise kombinierbar sind.

In einer weiteren Ausführungsform weist jedes Teilstück ein entsprechendes auf ein Teilungsraster festgelegtes Layout auf. Damit kann auf einer gegebenen Plattform eine effiziente Zusammenstellung erfolgen, wobei die Gesamteigenschaften gut überschaubar and einfach berechenbar sind aufgrund des festgelegten Layouts der Teilstücke.

In einer weiteren Ausführungsform ist mindestens eine Sorte an Teilstücken vorgesehen, die keine Einzeltransistorzellen aufweisen. Auf diese Weise lässt sich die Flexibilität des Verfahrens noch weiter erhöhen.

In einer weiteren Ausführungsform enthält die mindestens eine Sorte an Teilstücken ohne Einzeltransistorzellen Teilstücke mit Randbereichen.

In einer weiteren Ausführungsform ist mindestens ein Teilstück vorgesehen, das keine Randbereiche aufweist.

In einer weiteren Ausführungsform ist mindestens ein Teilstück vorgesehen, das ein Bondpad-Layout umfasst.

In einer weiteren Ausführungsform ist mindestens ein Teilstück vorgesehen, das ein Drain- und/oder Sourceanschluss-Layout umfasst.

In einem Aspekt umfasst das Verfahren Erzeugen zumindest einiger unterschiedlicher Layout-Teilstücke durch Aufteilen eines vollständigen Layouts eines vertikalen MOS-Leistungstransistors mit bekannten Entwurfsdaten. Auf diese Weise können in sehr flexibler Weise die benötigten Programmobjekte erstellt werden und für das weitere Entwerfen von Transistoren benutzt werden, wobei sodann die konstruktiven Besonderheiten des Ausgangslayouts in die neue Entwurfsarbeit einfließen.

In einer weiteren Ausführungsform umfasst das Aufteilen: Erzeugen mehrerer unterschiedlicher Sorten von Teilstücken, wobei Teilstücke jeder Sorte gleich Konfiguration und gleiche Entwurfsdaten besitzen und Berechnen der Entwurfsdaten jeder Sorte aus den bekannten Entwurfsdaten des vollständigen Layouts, um genormte Teilstücke für auf ein Teilungsraster festgelegtes Layout zu erhalten.

In einem noch weiteren Aspekt wird die Aufgabe gelöst durch ein System zum Entwerfen von vertikalen MOS-Leistungstransistoren, die für unterschiedliche Leistungen ausgelegt sind. Das System umfasst eine computer-gestützte Plattform zur Erzeugung eines Layouts aus vorgegebenen Layoutteilstücken gemäß einem ausgewählten Teilungsraster, wobei das Layout den konstruktiven Aufbau der vertikalen MOS-Leistungstransistoren festlegt, zwei oder mehr unterschiedliche Teilstücke mit jeweils unterschiedlicher Funktion und entsprechenden Entwurfsdaten, wobei mindestens ein erstes Layout-Teilstück mit einer bestimmten Anzahl identischer Einzeltransistorzellen vorgesehen ist und Teilstücke vorgesehen sind, die in Kombination mit dem ersten Teilstück zu einem Layout eines vollständigen vertikalen MOS-Leistungstransistors kombinierbar sind und wobei die Leistung der Layouts der vertikalen MOS-Leistungstransistoren durch die Anzahl der ersten Layout-Teilstücke definiert ist.

Die Erfindung wird nun anhand von Ausführungsbeispielen unter Zuhilfenahme der schematischen Zeichnung erläutert. Es zeigen

**Figur 1**    einen vertikalen Leistungstransistor mit einer ersten Fläche in Aufsicht

**Figur 2**    einen vertikalen Leistungstransistor mit einer gegenüber in Fig. 1 kleineren zweiten Fläche,

**Figur 3**    einen in Einzelstücke zerteilten vertikalen Leistungstransistor,

**Figur 4**    einen aus Einzelstücken zusammengesetzten vertikalen Leistungstransistor mit einer in Fig. 1 gezeigten ersten Fläche,

**Figur 5**    einen aus Einzelstücken zusammengesetzten vertikalen Leistungstransistor mit einer der in Fig. 2 gezeigten zweiten Fläche,

**Figur 6**    einen in Einzelstücke zerteilten vertikalen Leistungstransistor mit zerteilter Randstruktur und

**Figur 7**    einen in Einzelstücke zerteilten vertikalen Leistungstransistor mit einem Stück, welches eine Bondpad-Öffnung enthält.

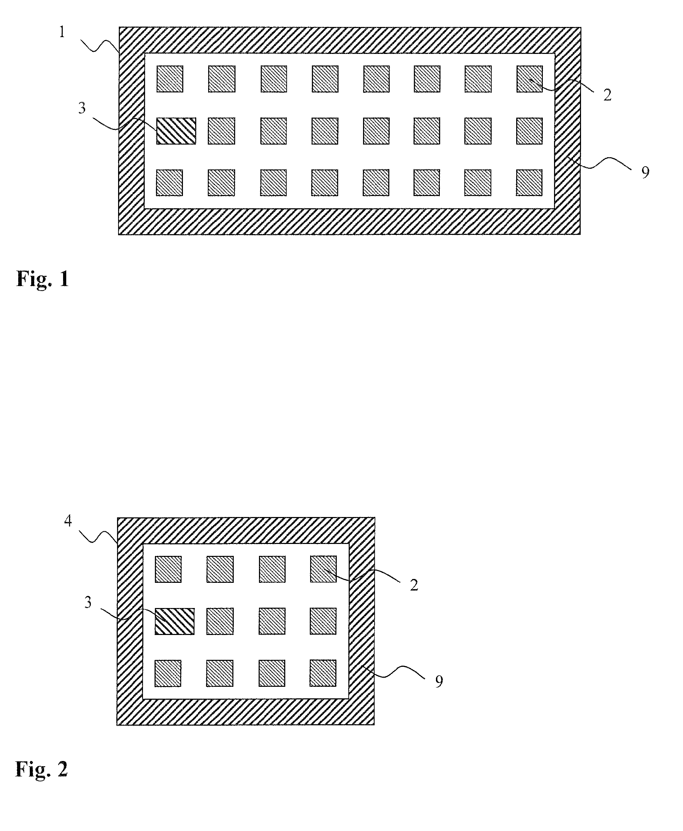

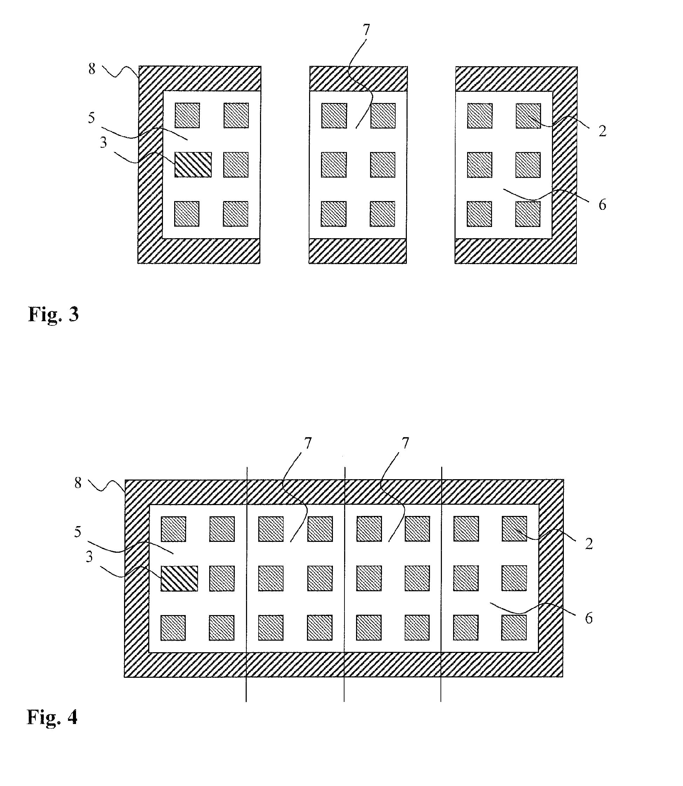

In Fig. 1 ist ein Transistor 1, d.h. ein Layout, das einem bestimmten vertikalen Leistungstransistor entspricht, gezeigt und dieses Layout wird gemäß Fig. 3 in unterschiedliche Teilstücke zerlegt: ein erstes Endstück 5, welches auch z.B. einen Gateanschluss 3 enthält, ein zweites Endstück 6 sowie ein Mittelstück 7. Jedes dieser Teilstücke enthält eine gewisse Anzahl von Einzeltransistorzellen 2 und ein entsprechendes Teilstück einer Randstruktur 9, wie sie in Fig. 1 gezeigt ist.

In Fig. 4 ist ein Transistor 8, d.h., dessen Layout, gezeigt, das dem des Transistors 1 in der Fläche gleicht, wobei der Transistor 8 in diesem Beispiel nun aus dem ersten Endstück 5, dem zweiten Endstück 6 und zwei Mittelstücken 7 aufgebaut ist. Die Parameter des zusammengesetzten Transistors können nun aus den bekannten Parametern der Einzelstücke berechnet werden.

Die Fläche des Transistors 8 setzt sich zusammen aus der Fläche der beiden Endstücke 5 und 6 und der zweifachen Fläche des Mittelstückes 7. Durch Einfügen weiterer Mittelstücke 7 kann die Fläche des Transistors nahezu beliebig vergrößert werden. Die Fläche eines zusammengesetzten Transistors mit Mittelstücken der Anzahl x lässt sich beschreiben durch

$$A_{\text{Transistor}} = A_{\text{Endstück5}} + A_{\text{Endstück6}} + x^*A_{\text{Mittelstück7}}$$

Auf die gleiche Weise kann die Kapazität des zusammengesetzten Transistors 8 ermittelt werden. Abgeleitet aus der bekannten Formel für die Parallelschaltung von Kondensatoren kann die Kapazität des zusammengesetzten Transistors beschrieben werden durch:

$$C_{\text{Transistor}} = C_{\text{Endstück5}} + C_{\text{Endstück6}} + x^*C_{\text{Mittelstück7}}$$

Abgeleitet aus der bekannten Formel für die Parallelschaltung von Widerständen kann der Widerstand des aus einem Endstück 5, einem Endstück 6 und Mittelstücken der Anzahl x zusammengesetzten Transistors beschrieben werden durch:

$$1/R_{\text{Transistor}} = 1/R_{\text{Endstück5}} + 1/R_{\text{Endstück6}} + x^*1/R_{\text{Mittelstück7}}$$

Die Größe des Mittelstückes 7 bestimmt in diesem Ausführungsbeispiel die Schrittweite der möglichen Flächenabstufungen d.h. mit großen Mittelstücken 7 können grobe Abstufungen der Fläche erzeugt werden. Mit kleinen Mittelstücken 7 können dagegen feinere Abstufungen erzeugt werden. Die Größe der Einzeltransistorzelle bestimmt dabei die minimal mögliche Größe des Mittelstücks 7.

Soll ein Transistor entworfen werden, der beispielsweise dem Transistor 4, d.h., dem Layout aus Fig. 2 entspricht, so kann dies durch ein Zusammenfügen der beiden Endstücke 5 und 6 erfolgen. Dies stellt auch den Transistor mit der minimal möglichen Fläche dar, wenn eine vorgegebene Sorte an Mittelstücken 7 vorgesehen ist. Es können auch andere Mittelstücke verwendet werden, um damit die Designflexibilität zu erhöhen.

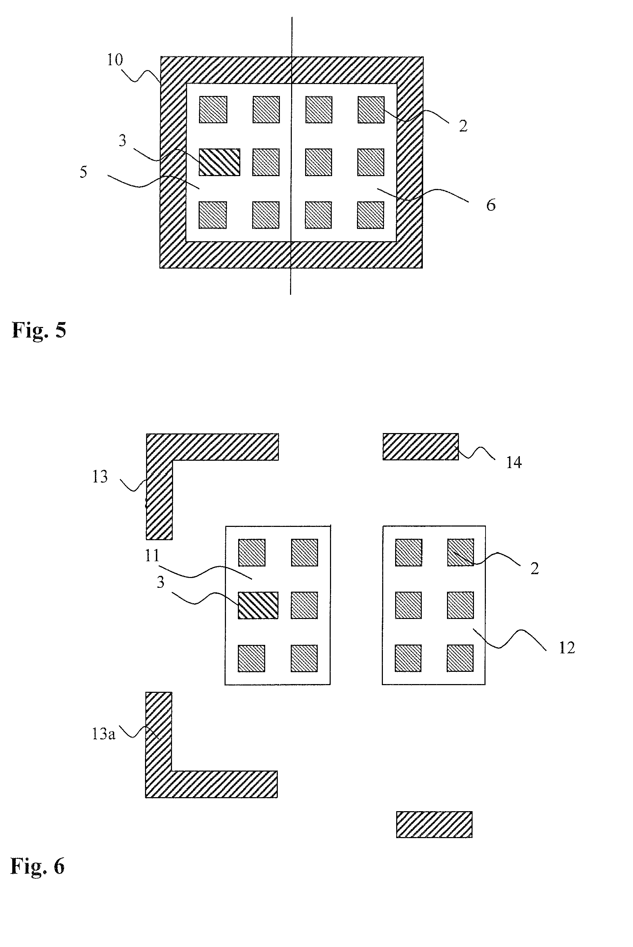

Fig. 6 zeigt weitere Möglichkeiten bzw. Ausführungsbeispiele zur Verwendung oder Erzeugung verschiedener Sorten an Layout-Teilstücken, die beim Entwerfen als Ausgangsobjekte dienen können, um die gewünschte Transistorstruktur als Layout zu erstellen. Beispielsweise kann die Randstruktur ebenfalls in Einzelstücke aufgeteilt werden. Damit besteht der zerteilte Transistor aus einem Endstück 11 das z.B. einen

Gateanschluss 3 enthält, aus einem Mittelstück 12, das eine definierte Anzahl von Einzeltransistorzellen 2 enthält, einem Teilstück der Randstruktur 13, das in gedrehter oder gespiegelter Form 13a die Ecken bildet, sowie einem geraden Randstück 14.

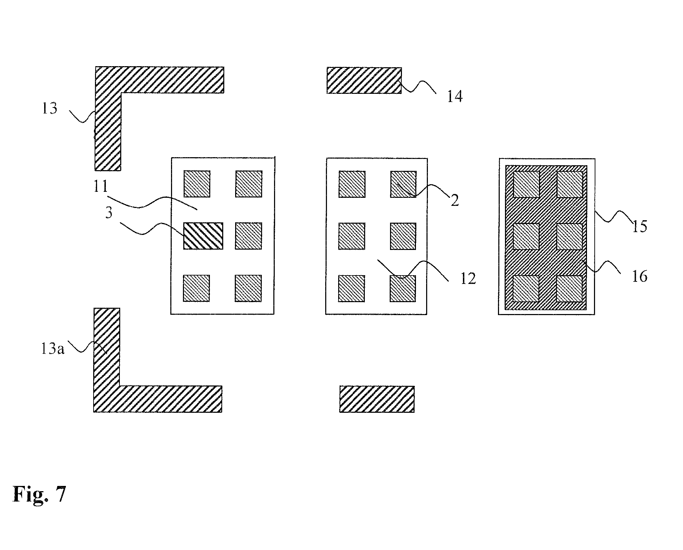

Fig. 7 zeigt ein Stück eines zerteilten Transistors 15, d.h., seines Layouts, das eine weitere Struktur enthält. Im aufgeführten Beispiel handelt es sich um eine Bondpadöffnung 16, wie sie bei diskreten Leistungstransistoren verwendet wird. Es kann sich in anderen Ausführungsbeispielen auch um andere Strukturen handeln, z.B. den Drain- oder Sourceanschluss eines integrierten Leistungstransistors.

Die in den Figuren gezeigten Teilstücke repräsentieren somit effiziente Entwurfshilfsmittel, die in einer Computer gestützten Plattform (nicht gezeigt), entsprechend den zuvor dargestellten Prinzipien erzeugt und/oder zusammengestellt werden können, um eine Vielzahl unterschiedlicher Transistorentwürfe mit unterschiedlichen Leistungen zu erstellen.

Eine vorteilhafte Ausführungsform umfasst ein Verfahren zum konstruktiven Aufbau von vertikalen MOS-Leistungstransistoren, die für unterschiedliche Leistungen ausgelegt sind. Das Verfahren umfasst, dass diese als Kombination von unterschiedlichen genormten Teilstücken zu einem Gesamt-Bauelementaufbau zusammengesetzt werden, von denen jedes dieser genormten Teilstücke einer spezifischen Funktion entspricht und ein entsprechendes auf ein Teilungsraster festgelegtes Layout besitzt und bekannte Daten beinhaltet, wobei ein Teilstück, etwa das Teilstück 7, eine bestimmte Anzahl von stets gleichen Einzeltransistorzellen in gleicher geometrischer Anordnung zusammen mit einem bestimmten Abschnitt des genormten Randbereiches 9 umfasst, ein anderes Teilstück, etwa das Teilstück 5, eine bestimmte Anzahl von gleichen Transistorzellen zusammen mit dem Gate-Anschluss 3 und einem anderen Abschnitt des Randbereiches 9 enthält und ein weiteres Teilstück, etwas das Teilstück 6, eine bestimmte Anzahl von gleichen Transistorzellen zusammen mit einem weiteren bestimmten Abschnitt des Randbereiches umfasst und diese Teilstücke zu Bauelementeeinheiten unterschiedlich großer Gesamtfläche kombiniert werden, wobei sich die Leistungsabstufung durch die Größe des die Mitte der Bauelementfläche bildenden Teilstücks ergibt.

Eine weitere vorteilhafte Ausführungsform umfasst ein Verfahren zum konstruktiven Aufbau von vertikalen MOS-Leistungstransistoren, die für unterschiedliche Leistungen ausgelegt sind, wobei das Verfahren beinhaltet, diese als Kombination von unterschiedlichen genormten Teilstücken zu einem Gesamt-Bauelementaufbau zusammenzusetzen, von denen jedes dieser genormten Teilstücke einer spezifischen Funktion entspricht und ein entsprechendes auf ein Teilungsraster festgelegtes Layout besitzt und bekannte Daten beinhaltet, wobei ein erstes Teilstück, etwa das Teilstück12, eine bestimmte Anzahl von stets gleichen Einzeltransistorzellen 2 in gleicher geometrischer Anordnung umfasst, ein zweites Teilstück, etwa das Teilstück 11, eine bestimmte Anzahl von gleichen Transistorzellen zusammen mit dem Gate-Anschluss 3 enthält, ein drittes Teilstück, etwa das Teilstück15, geöffnete Bondpads besitzt und weitere Teilstücke vorhanden sind, die bestimmte Abschnitte des Randbereiches, etwa die Bereiche 13, 13a, 14, bilden und diese Teilstücke zu Bauelementeeinheiten unterschiedlich großer Gesamtfläche kombiniert werden, wobei sich die Leistungsabstufung durch die Größe des die Mitte der Bauelementfläche bildenden Teilstücks, etwa des Teilstücks 12, ergibt.

In einer weiteren Ausführungsform enthält das Bauelement das dritte Teilstück, etwa das Teilstück 15, nicht.

In einer weiteren Ausführungsform kann das dritte Teilstück auch mit anderen Funktionselementen als Bondpads versehen sein.

**Patentansprüche**

1. Verfahren zur Erzeugung genormter Layout-Teilstücke zum Entwerfen von vertikalen MOS-Leistungstransistoren, die für unterschiedliche Leistungen ausgelegt sind, mit den Schritten:

   - Erzeugen zumindest einiger unterschiedlicher Layout-Teilstücke (5, 6, 7, 13, 13a, 14) durch Aufteilen eines vollständigen Layouts mit mehreren Einzeltransistorzellen eines vertikalen MOS-Leistungstransistors mit bekannten Entwurfsdaten;
   - Erzeugen mehrerer unterschiedlicher Sorten von Teilstücken, wobei Teilstücke jeder Sorte gleiche Konfiguration und gleiche Entwurfsdaten besitzen;
   - Berechnen der Entwurfsdaten jeder Sorte aus den bekannten Entwurfsdaten des vollständigen Layouts, um genormte Teilstücke für ein auf ein Teilungsraster festgelegtes Layout zu erhalten.

**2.** Verfahren nach Anspruch 1, wobei mindestens ein Teilstück vorgesehen ist, das ein Drain- und/oder Sourceanschluss-Layout umfasst.

**3.** Verfahren nach Anspruch 1, wobei die Einzeltransistorzellen (2) von gleicher Konfiguration sind.

**4.** Verfahren nach einem der Ansprüche 1 oder 3, wobei zumindest einige der Teilstücke (5, 6, 7, 13, 13a, 14) Randbereiche enthalten, die abschnittsweise zusammenfügbar sind, um einen vollständigen Randbereich im Layout des vertikalen MOS-Leistungstransistors zu bilden.

**5.** Verfahren nach Anspruch 4, wobei Teilstücke mit gleichem Randbereich eine bestimmte Anzahl von gleichen Einzeltransistorzellen in gleicher geometrischer Anordnung aufweisen.

**6.** Verfahren nach einem der vorigen Ansprüche, wobei eine Sorte aus Teilstücken (5) erzeugt wird, die zumindest einen Gateanschluss (3) aufweist.

**7.** Verfahren nach einem der vorigen Ansprüche, wobei mindestens eine Sorte von Teilstücken (13, 13a, 14) erzeugt wird, die keine Einzeltransistorzellen aufweisen.

**8.** Verfahren nach Anspruch 7, wobei die mindestens eine Sorte von Teilstücken ohne Einzeltransistorzellen Teilstücke mit Randbereichen enthält.

**9.** Verfahren nach einem der vorigen Ansprüche, wobei mindestens eine Sorte von Teilstücken (12, 15) erzeugt wird, die keine Randbereiche aufweisen.

**10.** Verfahren nach einem der vorigen Ansprüche, wobei mindestens ein Teilstück vorgesehen ist, das ein Bondpad-Layout umfasst.

**Fig. 1**

**Fig. 2**

**Fig. 3**

**Fig. 4**

**Fig. 5**

**Fig. 6**

**Fig. 7**

Europäisches
Patentamt
European
Patent Office
Office européen
des brevets

**EUROPÄISCHER RECHERCHENBERICHT**

Nummer der Anmeldung

EP 11 17 3339

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2003/209766 A1 (BLANCHARD RICHARD A [US]) 13. November 2003 (2003-11-13) * Zusammenfassung * * Abbildungen 1,2a,2b,10,13,14,15 * * Absatz [0002] - Absatz [0005] * * Absatz [0031] - Absatz [0037] * * Absatz [0049] - Absatz [0070] * * Ansprüche 1-14 * ----- | 1-10 | INV. G06F17/50 ADD. H01L29/78 |
| A | FOURNERIS G ET AL: "Demosthenes-A technology-independent power DMOS layout generator", DESIGN AUTOMATION CONFERENCE, 1993, WITH EURO-VHDL '93. PROCEEDINGS EU RO-DAC '93., EUROPEAN HAMBURG, GERMANY 20-24 SEPT. 1993, LOS ALAMITOS, CA, USA,IEEE COMPUT. SOC, US, 20. September 1993 (1993-09-20), Seiten 178-183, XP010144052, DOI: 10.1109/EURDAC.1993.410634 ISBN: 978-0-8186-4350-7 * das ganze Dokument * ----- | 1-10 | |
| A | US 5 844 277 A (HSHIEH ET AL) 1. Dezember 1998 (1998-12-01) * das ganze Dokument * ----- | 1-10 | RECHERCHIERTE SACHGEBIETE (IPC) G06F H01L |

Der vorliegende Recherchenbericht wurde für alle Patentansprüche erstellt

| Recherchenort | Abschlußdatum der Recherche | Prüfer |
|---|---|---|
| München | 19. September 2011 | Alonso Nogueiro, L |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
...............................................................................................
& : Mitglied der gleichen Patentfamilie, übereinstimmendes
  Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 11 17 3339

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-09-2011

| Im Recherchenbericht angeführtes Patentdokument | Datum der Veröffentlichung | Mitglied(er) der Patentfamilie | Datum der Veröffentlichung |
|---|---|---|---|
| US 2003209766 A1 | 13-11-2003 | KEINE | |
| US 5844277 A | 01-12-1998 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5844277 A
- US 5763914 A
- US 6769007 A
- US 6651236 A
- US 6591408 A

**In der Beschreibung aufgeführte Nicht-Patentliteratur**

- **BALIGA.** *Power Semiconductor Devices,* 1995, 367ff